# EUROPEAN PATENT APPLICATION

(11) **EP 2 111 024 A1**
(43) Date of publication of application: **21.10.2009**
(21) Application number: 08103574.3
(22) Date of filing: 16.04.2008
(51) Int. Cl.: H04M 1/30

(54) **Detection of devices and fault conditions by means of U/I or I/U characteristics**

(71) Applicant: Nokia Siemens Networks Oy, 02610 Espoo (FI)
(72) Inventor: Cierpka, Ralf, 17489, Greifswald (DE)

(57) **Abstract**

The invention relates to a test method for subscriber lines in complex communication systems, in which voltage ramps, preferably with a constant slope, are applied to the two wires of the subscriber line, and the resulting current curves are measured, generating U / I characteristics that are compared to predetermined U / I characteristics, which are specific for each type of device connected to the subscriber line and for fault conditions such as short circuits or defective high-voltage protectors, allowing to manually or automatically identify a device connected to the subscriber line and its functioning state, or a fault condition.

## Description

The invention relates to a test method for measuring the state of a subscriber line with two electrically conductive wires, and for determining one or more characteristics from the measurements and for determining the type of devices connected to the line and for detecting fault conditions on the line by means of the determined characteristics.

A functioning telephone connection is an important prerequisite for ensuring that telecommunications subscribers can rely on the services and features of a telecommunications network.

On an increasing scale, telecommunication companies employ convenient remote diagnostics to quickly and inexpensively detect fault conditions in the subscriber networks.

During reconstruction, expansion and modernization of the network, a great deal of attention is devoted to the integration of measuring devices for the detection of fault conditions.

EP 0580893, for example, introduces measuring heads or integrated line test functions offered by suppliers of network technology.

Traditionally, copper networks provided POTS or ISDN services. Thus, the integrated measuring technology was adapted to these services. But the lines of telecommunications networks are charged with more and more services combining various technologies.

Also, various providers share a copper line to render their services. In this case the copper line is not only connected to terminals (CPE), but also to additional facilities like a passive test termination in the connector box (PPA), splitters and various broadband and narrowband network terminators of different providers, which are often installed by the customers themselves. This means an increase in diversity of the additional facilities in copper networks and, accordingly, in the frequency of fault conditions. The various service providers can not analyze exactly what caused the fault condition, and consequently who is responsible for its repair.

The integrated measuring technology known in the art, described by the patent DE699330455T2, measures noise voltage, resistors, capacitors and impedances at high voltages on the subscriber lines, wherein, due to the high number of measuring heads, no statement can be made on the prevailing measuring conditions. Customer- and country-specific test methods and parameters are defined for each connected facility.

This known measuring technology does not provide an inexpensive and accurate analysis of the increasingly complex networks. If, for example, ISDN and xDSL are combined on one copper line, this creates a nonlinear resistor curve as a function of the measuring voltage, which can not easily be captured by the technology known today. Instead, for each connected facility specific measuring processes need to be programmed. Also, newer CPE can not be detected by the measuring methods known today. The complex mix of different technologies causes an increasing number of measuring errors and, at present, an exact analysis of a network is hardly possible.

If advanced facilities are integrated in the copper network - such as, for example, various splitters that are needed for broadband xDSL technology - new software implementations of test routines are necessary. This means, adaptations need to be developed constantly when the network changes due to the insertion of new components. Adaptations of the reference equivalent circuit diagrams become difficult or impossible if different service providers freely sell components and add them to the network. The precision of the conventional measuring methods is further reduced by tolerances of the additional facilities and specifics of the copper network.

It is the aim of the invention to provide a test method which avoids the above-mentioned drawbacks of conventional test methods and complements them to the extent that tests on the subscriber lines can be implemented and adapted to changes with little effort and also achieve a sufficient reliability of the test results in complex networks.

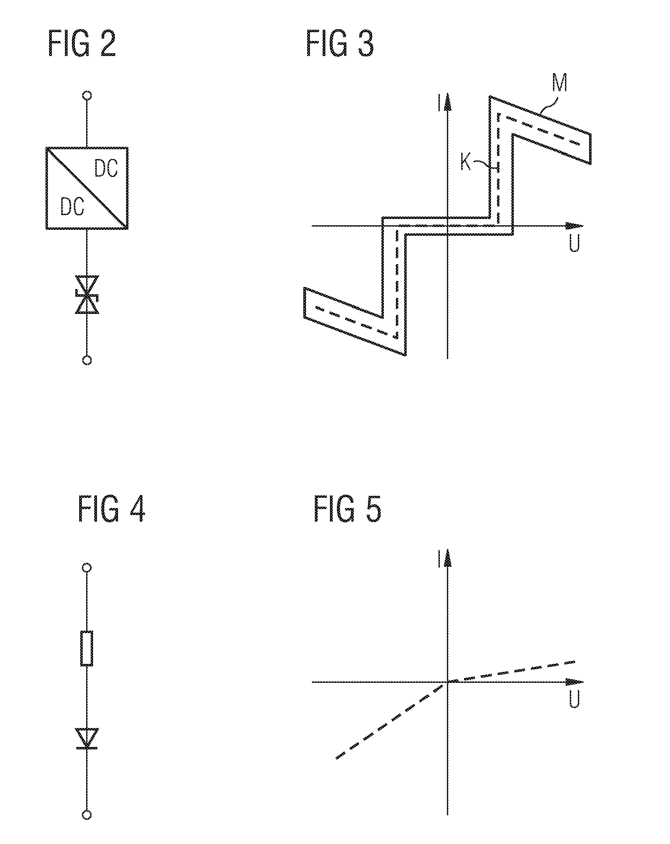

This task is solved by the invention as follows: A measuring head captures voltage/current characteristics (U/I curves), or current/voltage characteristics (I/U curves) for the two wires of the subscriber line. Time-variable voltages or currents are applied to both wires of the subscriber line and the resulting voltages or currents are determined and stored in such a way that the temporal relation between voltage and current is maintained. The U/I or I/U characteristics are made available for an external evaluation system via an interface of the testing facility. Previously determined typical masks or evaluations of vector changes in the resulting curves are used to evaluate the V/I curves and thus to detect fault conditions or the existence and functioning state of a device on the subscriber line. Figure 2 to Figure 9 show examples of typical U/I characteristics for different facilities connected to the subscriber line.

The resistances detected in the test methods known in the art contain no information about the voltage or current that has been used for their determination. The invention makes it possible for the network operator to display the curve of resistance as a function of the measuring voltage and thereby obtain the test result. The accuracy of the measured values is improved, since nonlinear areas of the U/I curve or areas of saturation of the measuring head can now be reevaluated.

In another favourable embodiment voltages or currents with a constant slope over time (dU/dt and dI/dt) are used as variable voltages or currents. This way charging currents of capacities or inductors can be detected.

In another advantageous embodiment of the invention are two data sets are captured for each measurement: one with a positive dU/dt and the corresponding resulting current I1 (U), and one with a negative dU/dt and the corresponding resulting current 12 (U). From these two data sets the active current - I_a (U) = (I1 (U) + 12 (U)) / 2 - and the reactive current - I_r (U) = (I1 (U) - 12 (U)) / 2 - can be calculated.

The result, in accordance with the invention, are defined U/I characteristics for a subscriber line with a connected CPE and additional facilities. If the characteristics are captured with a constant dU/dt, also facilities behind a capacity on the subscriber line can be seen. This is especially important for the detection of terminal units, since the ringer capacities of newer devices are small and hard to differentiate from the line capacity.

Capturing two U/I characteristics is sufficient as the sole measurement for the described test methods, to determine fault conditions and connected facilities. Therefore, no measuring processes with different parameters - specific to the circuit, country or network provider - are necessary. Only the evaluation needs to be adapted to the specifics. Thus the electrical recording of the characteristics can easily be integrated in a test facility or in appropriate line card chips and does not need to be changed later on.

According to a further claim, the test method according to the invention can be combined with existing test methods, e.g. with impedance measuring at higher frequencies. This further increases the advantages of the invention, because network operators can combine this method with their specific experiences concerning elements of traditional test methods.

The outline of the invention is described in the figures by way of example.
- Figure 1: shows an example of a network configuration;
- Figure 2: shows an electrical equivalent circuit diagram for an ISDN NTBA;
- Figure 3: shows the U/I characteristic corresponding to Figure 2;
- Figure 4: shows an electrical equivalent circuit for a POTS phone with test termination;
- Figure 5: shows the U/I characteristic corresponding to Figure 4;
- Figure 6: shows an electrical equivalent circuit for an xDSL splitter;
- Figure 7: shows the U/I characteristic corresponding to Figure 6;
- Figure 8: shows an electrical equivalent circuit for a short circuit condition;
- Figure 9: shows the U/I characteristic corresponding to Figure 8.

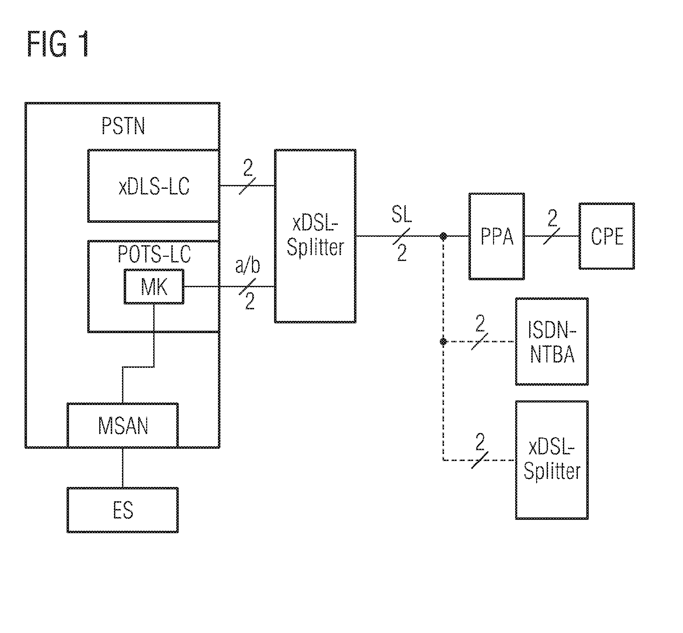

A PSTN is displayed in Figure 1, containing an xDSL line card xDSL-LC. This line card generates DSL signals which are routed to an xDSL splitter via a pair of wires. The splitter combines the DSL signals with the analogue signals of a traditional POTS line card LC, thus creating a mixed signal which is applied to the two-wire copper line SL. By way of example, a PPA with CPE (solid line), or alternatively an ISDN NTBA or xDSL Splitter (dashed lines) are connected at the subscribe side of the subscriber line. The POTS line card LC contains a measuring head MK, which applies currents or voltages to the connected wires a/b and measures the resulting voltages and currents. The measuring head MK generates U/I or I/U characteristics from the previously measured values and, via an interface MSAN, delivers them to an expert system ES. The characteristics are compared with stored characteristic masks which are specific for facilities on the subscriber line and for fault conditions. If the curve lies within one of the stored masks, the facility corresponding to the stored mask, or a fault condition corresponding to another saved mask, can be identified.

Figure 2 shows the equivalent circuit diagram of an ISDN NTBA, consisting of a combination of Zener diodes and a DC converter DC/DC.

The U/I characteristic K of Figure 3 shows that in the case of the application of a variable voltage U, a current I flows only when a certain voltage is reached. The current is smaller at higher voltages, since the product of voltage and current is approximately constant, as long as the power supplied to the ISDN NTBA remains constant. If the U/I characteristic lies within in a mask M, the existence of an ISDN NTBA can be concluded.

Figure 4 is the equivalent circuit diagram of a test termination PPA, consisting of a resistor and a diode.

Figure 5 shows that the quotient of voltage and current is smaller for positive voltages than for negative voltages, since in the case of a negative voltage, the resistor takes effect due to the diode (as shown in the equivalent circuit 4). The presence of a PPA can be concluded from the U/I characteristic.

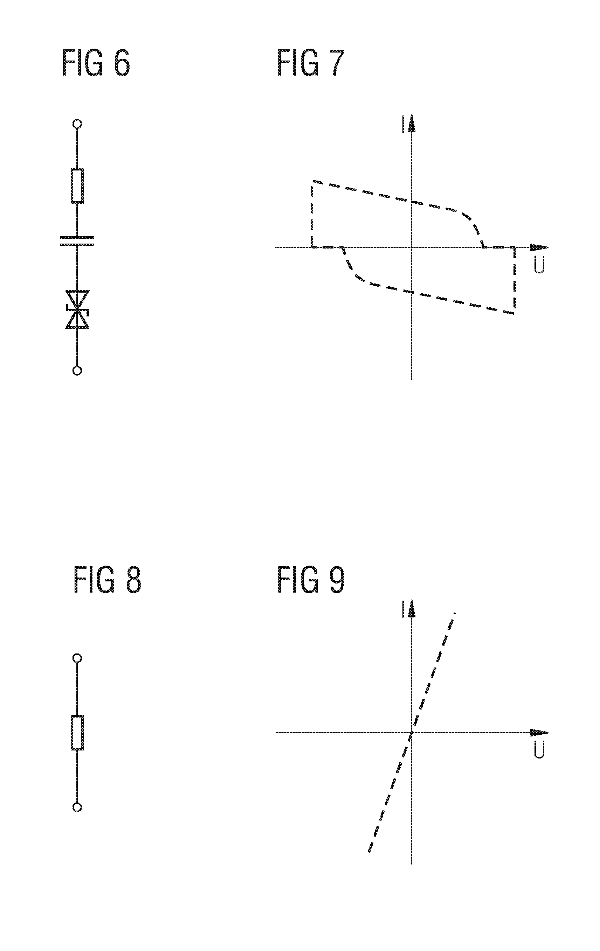

Figure 6 is the equivalent circuit diagram of an xDSL splitter, consisting of a resistor, a capacitor and a combination of Zener diodes.

Figure 7 shows that a voltage ramp with a positive slope generates a different characteristic than a voltage ramp with a negative slope, which is due to the effect of the capacitor. The presence of an xDSL splitter can be concluded from the U/I characteristic.

Figure 8 shows a resistor as the equivalent circuit diagram of a short circuit on the wires a/b.

Figure 9 displays the U/I characteristic as a straight line, the slope of which allows to identify the existence and the location of a short circuit.

### References

- a/b: copper line
- CPE: customer premises equipment
- DC/DC: direct current converter
- DSL: digital subscriber line
- ES: expert system
- I: current
- ISDN: integrate services digital network
- K: characteristic
- LC: line card
- M: mask
- MK: measuring head
- MSAN: interface
- NTBA: network terminator base band
- PPA: passive test termination
- POTS: plain old telephone system
- PSTN: public switched telephone network
- SL: subscriber line
- U: voltage

## Claims

1. Test method for measuring the state of a subscriber line with two electrically conductive wires, and for determining one or more characteristics from the measurements and for determining the type of devices connected to the line and for detecting fault conditions on the line by means of the determined characteristics, **characterized in that** time-variable electrical voltages or currents are applied to each of the two wires of the subscriber line, and the resulting electrical current or voltage gradients on the two wires are measured and stored, and that the resulting U/I and I/U characteristic curves are compared with stored characteristic curves, which are specific for each type of device connected to the subscriber line and for fault conditions.

2. Method according to claim 1, **characterized in that** the existence and the functioning of a device connected to the subscriber line or the existence of an fault condition is determined manually or automatically, based on the measured characteristics.

3. Method according to one of the above claims, **characterized in that** voltage ramps with a constant slope dU/dt are used as time-variable voltages, by means of which the charge currents of capacities of the subscriber line, including the connected devices, are measured.

4. Method according to claim 1 or 2, **characterized in that** current ramps with a constant slope dI/dt are used as a time-variable currents, by means of which the charge currents of inductors of the subscriber line, including the connected devices, are measured.

5. Method according to one of the above claims, **characterized in that** for each measurement one voltage or current ramp with a positive slope and one with a negative slope are used, from the sum and difference of which active and reactive current or active and reactive voltage are calculated.

6. Method according to one of the above claims, **characterized in that** the determined characteristic is compared with a stored mask, and, if the characteristic curve lies within the mask, it is concluded that a device corresponding to the saved mask is connected to the subscriber line.

7. Method according to one of the above claims, **characterized in that** additional electrical parameters - such as alternating voltage, alternating currents and/or impedances between the wires or between one wire and a common point of reference with the other wire - are determined in addition to the characteristic curves, and that additional results are derived from the combination of the other electrical parameters with the determined characteristic curves.
